# EUROPÄISCHE PATENTSCHRIFT

(11) **EP 0 524 547 B1**
(45) Veröffentlichungstag und Bekanntmachung des Hinweises auf die Patenterteilung: **09.10.1996**
(21) Anmeldenummer: 92112166.1
(22) Anmeldetag: 16.07.1992
(51) Int. Cl.: H04M 1/60, H03G 3/20

(54) **Steuerbare Verstärkerschaltungsanordnung**
Controllable amplifier circuit
Circuit amplificateur réglable

(30) Priorität: 24.07.1991 DE 4124585
(43) Veröffentlichungstag der Anmeldung: 27.01.1993
(73) Patentinhaber: SIEMENS AKTIENGESELLSCHAFT, 80333 München (DE)
(72) Erfinder: Bardl, Artur, Dipl.-Ing., W-8000 München 70 (DE); Lindner, Manfred, Dipl.-Ing., W-8025 Unterhaching (DE); Navratil, Emil, W-8000 München 80 (DE)

(56) Entgegenhaltungen:
- EP-A- 0 271 947
- EP-A- 0 353 808
- EP-A- 0 380 819
- IEEE JOURNAL OF SOLID-STATE CIRCUITS Bd. SC-17, Nr. 3, Juni 1982, NEW YORK Seiten 494 - 498 EBERHARDT ET AL 'AN INTEGRATED TELEPHONE SPEECH CIRCUIT INCLUDING A LINE FED LOUDSPEAKER AMPLIFIER'

## Beschreibung

Die übertragungstechnischen Eigenschaften von bipolaren Schaltkreisen insbesondere bei Anwendungen in Telefonschaltungen werden weitgehend durch diskrete Bauelemente wie Widerstände, Kondensatoren und Drosseln bestimmt. Bei Sprechschaltungen für Telefonendgeräte werden beispielsweise zur Einstellung der Gesamtverstärkungen externe Widerstände verwendet, die eine hohe Genauigkeit und eine fertigungsstreuungsunabhängige Reproduzierbarkeit gewährleisten und die ein Verändern der Verstärkungen in Sende- und Empfangsrichtung erlauben. Eine derartige Schaltung ist z. B. aus Siemens Data Book 1989/90, ICs for Communication, PSB 4505/4506, Seiten 782 bis 811, bekannt.

Zum Ändern der Verstärkungen werden üblicherweise die entsprechenden externen Bauteile ausgewechselt bzw. neu abgeglichen. Dies ist jedoch vor allem bei nachträglichen Korrekturen mit einigem Aufwand verbunden. Insbesondere zur Anpassung der Verstärkung wie auch anderer Parameter an die unterschiedlichen Vorschriften für Telefonanlagen verschiedener Länder wäre daher eine möglichst automatisierte, bevorzugt softwaregesteuerte Einstellung einzelner Parameter von großem Nutzen. Dies ist bei den bekannten Schaltungskonzepten im allgemeinen nur mit einem erheblichen zusätzlichem Schaltungsaufwand und im besonderen mit einer Zunahme der Anzahl externer Bauelemente möglich.

Aufgabe der Erfindung ist es daher, eine steuerbare Schaltungsanordnung mit geringem schaltungstechnischen Aufwand anzugeben.

Die Aufgabe wird durch eine Schaltungsanordnung gemäß Patentanspruch 1 gelöst. Ausgestaltungen und Weiterbildungen des Erfindungsgedankens sind in den Unteransprüchen gekennzeichnet.

Vorteile der Erfindung sind neben dem insgesamt geringen Schaltungsaufwand die vollständige Integrierbarkeit, die Möglichkeit einer aufwandsarmen Realisierung eines analogen Bussystems sowie die Möglichkeit der Softwaresteuerung.

Die Erfindung wird nachfolgend anhand der in den Figuren der Zeichnung dargestellten Ausführungsbeispiele näher erläutert. Es zeigt:
- Figur 1: eine erste allgemeine Ausführungsform einer erfindungs-gemäßen Schaltungsanordnung und
- Figur 2: eine zweite detailierte Ausführungsform einer erfindungsgemäßen Schaltungsanordnung.

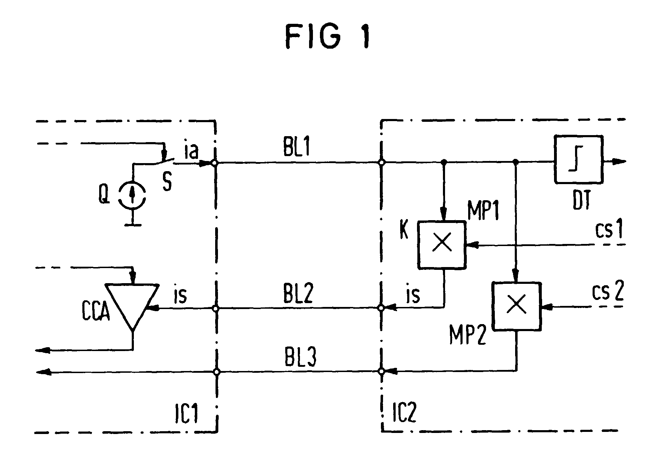

Die Schaltungsanordnung nach Figur 1 enthält erfindungsgemäß einen stromgesteuerten Verstärker CCA als Stellglied, der in bestimmten Schwankungen und Streuungen unterworfener Abhängigkeit von einem Steuerstrom is einstellbar ist, und mit einer Konstantstromquelle Q, deren Ausgangsstrom den bestimmten Schwankungen und Streuungen in gleicher Weise unterworfen ist. Um die von äußeren Einflüssen wie beispielsweise von fertigungsbedingten Streuungen und von der Temperatur abhängigen Schwankungen bei stromgesteuertem Verstärker CCA und Konstantstromquelle Q in Übereinstimmung zu bringen, werden diese zusammen in einen einzigen Schaltkreis integriert. Darüber hinaus werden die für die Schwankungen maßgeblichen Elemente bei stromgesteuertem Verstärker CCA und Konstantstromquelle Q möglichst identisch ausgeführt. Bei integrierten Schaltkreisen ist eine hohe absolute Genauigkeit elektrischer Größen für einzelne Elemente mit nur verhältnismäßig hohem Aufwand zu erzielen, während eine hohe relative Genauigkeit zwischen zwei identisch aufgebauten Elementen ohne größeren Aufwand erreicht wird.

Zur Einstellung der Verstärkung des stromgesteuerten Verstärkers CCA wird der Ausgangsstrom ia der Konstantstromquelle Q benutzt. Der Ausgangsstrom ia unterliegt aber fertigungsbedingten Streuungen und ist deshalb von Schaltkreis zu Schaltkreis unterschiedlich. Da dieser Strom ia im gleichen Schaltkreis als Steuerstrom is zur Verstärkungseinstellung des stromgesteuerten Verstärkers CCA, der den gleichen Fertigungsstreuungen unterworfen ist, mittelt sich die Fertigungsstreuung heraus. In gleicher Weise heben sich auch die temperaturbedingten Schwankungen von Konstantstromquelle Q und stromgesteuertem Verstärker CCA auf. Der Ausgangsstrom ia der Konstantstromquelle Q und der Steuerstrom is des stromgesteuerten Verstärkers CCA werden über einen Faktor k miteinander verknüpft. Durch Variation des Faktors k kann die Verstärkung des stromgesteuerten Verstärkers CCA verändert werden. Zu diesem Zweck ist zwischen Konstantstromquelle Q und dem stromgesteuerten Verstärker CCA eine Multipliziereinrichtung MP1 geschaltet, wobei der Faktor k von einem der Multipliziereinrichtung MP1 zugeführten Steuersignal cs1 abhängt. Die Abhängigkeit zwischen dem Steuersignal cs1 und dem Faktor k kann beliebig sein und ist beim Ausführungsbeispiel nach Figur 1 linear. Die Multipliziereinrichtung MP1 ist ebenso wie eine weitere, durch ein Steuersignal cs2 gesteuerte Multipliziereinrichtung MP2 und eine Detektoreinheit DT in einem weiteren Schaltkreis IC2 integriert. Beide Schaltkreise IC1 und IC2 sind über Busleitungen BL1, BL2, BL3 miteinander verbunden. Dabei koppelt die Busleitung BL1 die Stromeingänge der Multipliziereinrichtungen MP1 und MP2 sowie der Detektoreinheit DT mit der Konstantstromquelle Q. Der den Steuerstrom is führende Stromausgang der Multipliziereinrichtung MP1 ist über die Busleitung BL2 mit dem Steuereingang des stromgesteuerten Verstärkers CCA verbunden. An den Stromausgang der Multipliziereinrichtung MP2 ist über die Busleitung BL3 ein nicht näher bezeichnetes Stellglied des integrierten Schaltkreises IC1 angeschlossen. Dieses Stellglied kann beispielsweise neben einem stromgesteuerten Verstärker auch ein stromgesteuertes Filter oder ein stromgesteuerter Oszillator sein. Weiterhin sind der Eingang und der Ausgang des stromgesteuerten Verstärkers CCA sowie der Steueranschluß eines steuerbaren Schalters S, der zwischen die Konstantstromquelle Q und die Busleitung BL1 geschaltet ist und der ebenfalls Bestandteil des integrierten Schaltkreises IC1 ist, mit den weiteren Schaltungsteilen des integrierten Schaltkreises IC1 gekoppelt. In gleicher Weise sind weitere, nicht näher bezeichnete Schaltungsteile des integrierten Schaltkreises IC2 an den Ausgang der Detektoreinheit DT sowie an die Steuereingänge der Multipliziereinrichtungen MP1 und MP2 angeschlossen. Diese weiteren Schaltungsteile stellen auch die Steuersignale cs1 und cs2 bereit. Mit dem gesteuerten Schalter S in Verbindung mit der Detektoreinheit DT kann ein Signal vom integrierten Schaltkreis IC1 an den integrierten Schaltkreis IC2 übermittelt werden, das beispielsweise die Betriebsbereitschaft des integrierten Schaltkreises IC1 anzeigt. Dies geschieht dadurch, daß die Detektoreinheit DT erkennt, ob ein Strom vom integrierten Schaltkreis IC1 gesendet wird oder nicht.

Im integrierten Schaltkreis IC1 wird also ein Ausgangsstrom ia erzeugt, der im integrierten Schaltkreis IC2 mit dem Faktor k multipliziert und dem stromgesteuerten Verstärker CCA im integrierten Schaltkreis IC1 wieder zugeführt wird. Aus dem Ausgangsstrom ia des integrierten Schaltkreises IC1 können auf diese Weise beliebig viele - im vorliegenden Ausführungsbeispiel insgesamt zwei Steuerströme erzeugt und entsprechende Steuerglieder damit betrieben werden. Zudem ist es - wie im folgenden Ausführungsbeispiele gezeigt - möglich, daß die beiden integrierten Schaltkreise IC1 und IC2 in unterschiedlicher Technologie aufgebaut sind.

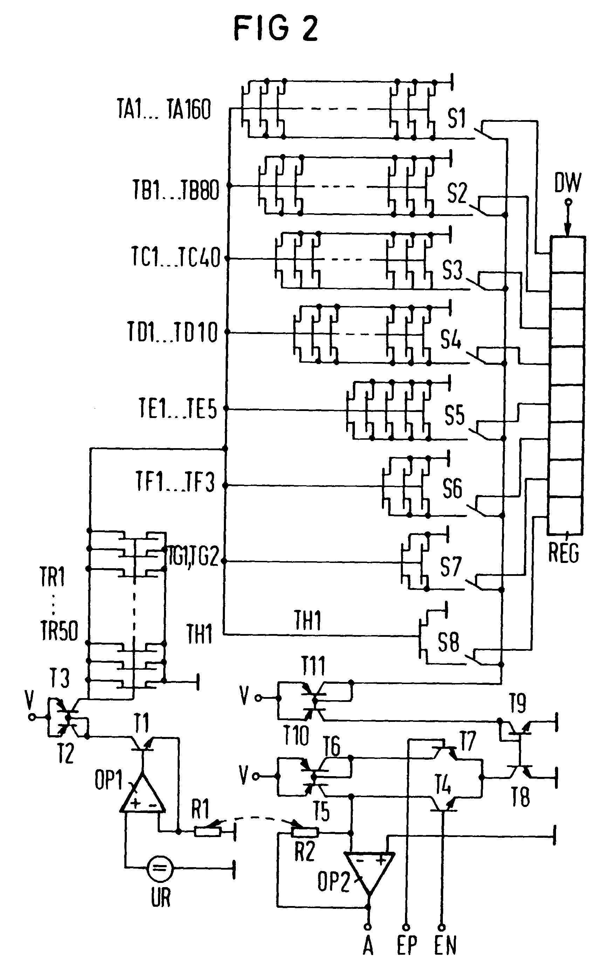

Die erfindungsgemäße Schaltungsanordnung nach Figur 2 ist zwar in einen einzigen Schaltkreis integriert, jedoch sind Konstantstromquelle und steuerbarer Verstärker in Bipolartechnik und die Multipliziereinrichtung in MOS-Technik ausgeführt. Durch Nutzung typischer Bipolar-bzw. MOS-Eigenschaften, insbesondere von CMOS-Eigenschaften wird eine Realisierung mit minimalem Schaltungsaufwand erreicht.

Beim gezeigten Ausführungsbeispiel besteht die Konstantstromquelle aus einem Operationsverstärker OP1, dessen nichtinvertierender Eingang unter Zwischenschaltung einer Referenzspannungsquelle UR mit einem Bezugspotential verbunden ist. Als Referenzspannungsquelle UR ist beispielsweise eine Bandgap-Referenzspannungsquelle vorgesehen. Der invertierende Eingang des Operationsverstärkers OP1 ist zum einen über einen Widerstand R1 mit dem Bezugspotential und Zum anderen mit dem Emitter eines npn-Transistors T1 verbunden. Der Ausgang des Operationsverstärkers ist auf die Basis des Transistors T1 geführt, dessen Kollektor mit dem Kollektor und der Basis eines pnp-Transistors T2 und der Basis eines pnp-Transistors T3 gekoppelt ist. Die Emitter der Transistoren T2 und T3 sind an ein Versorgungspotential V angeschlossen. Der stromgesteuerte Verstärker besteht aus einem Operationsverstärker OP2, der zwischen Ausgang und invertierendem Eingang über einen Widerstand R2 gegengekoppelt ist. Der Ausgang des Operationsverstärkers OP2 ist zudem mit einem Ausgangsanschluß A verbunden. Der nichtinvertierende Eingang des Operationsverstärkers ist auf Bezugspotential gelegt, während der invertierende Eingang außer mit dem Widerstand R2 zusätzlich mit dem Kollektor eines npn-Transistors T4 und mit dem Kollektor eines pnp-Transistors T5 verbunden ist. Der Emitter des Transistors T5 ist ebenso wie der Emitter eines pnp-Transistors T6, dessen Kollektor und Basis mit der Basis des Transistors T5 gekoppelt sind, an das Versorgungspotential V gelegt. Der Kollektor des Transistors T6 ist zudem mit dem Kollektor eines npn-Transistors T7 verschaltet, dessen Emitter mit dem Emitter des Transistors T4 und dem Kollektor eines npn-Transistors T8 verbunden ist. Die Basen der beiden Transistoren T4 und T7 bilden die symmetrischen Eingänge EN bzw. EP des stromgesteuerten Verstärkers. Die Basis des Transistors T8 ist mit Basis und Kollektors eines npn-Transistors T9 verbunden, dessen Emitter ebenso wie der Emitter des Transistors T8 auf Bezugspotential liegt. Der Kollektor des Transistors T9 ist mit dem Kollektor eines pnp-Transistors T10 gekoppelt, dessen Basis mit der Basis und dem Kollektor eines pnp-Transistors T11 verbunden ist. Die Emitter der Transistoren T10 und T11 sind an das Versorgungspotential V angeschlossen.

Die absolute Genauigkeit der Konstantstromquelle und des stromgesteuerten Verstärkers beim Ausführungsbeispiel nach Figur 2 hängt im wesentlichen von den Widerständen R1 und R2 ab. Bei üblichen Schaltungskonzepten werden daher diese Widerstände durch externe, diskrete Widerstände realisiert. Diese sind in weitaus geringerem Maße fertigungsbedingten Streuungen und temperaturabhängigen Schwankungen unterworfen. Dagegen werden bei der erfindungsgemäßen Schaltungsanordnung diese Widerstände, nämlich die Widerstände R1 und R2, mit in den Schaltkreis integriert. Anstelle einer hohen absoluten Genauigkeit wird eine wesentlich einfacher zu erzielende hohe relative Genauigkeit angestrebt. Dies wird insbesondere dann erreicht, wenn die beiden Widerstände R1 und R2 identisch aufgebaut sind. Falls unterschiedliche Werte für R1 und R2 benötigt werden, so kann bevorzugt durch Parallel- und/oder Serienschaltung identischer Widerstände der gewünschte Wert realisiert werden. Die übrigen Komponenten bei Konstantstromquelle und stromgesteuerten Verstärker sind hinsichtlich fertigungsbedingter Streuungen und temperaturabhängiger Schwankungen bei dieser Anordnung im wesentlichen unbedeutend.

Die Multipliziereinrichtung ist bei der in Figur 2 gezeigten erfindungsgemäßen Schaltungsanordnung als Stromspiegelanordnung ausgeführt, deren Übersetzungsverhältnis abhängig von einem binärkodierten Datenwort DW als Steuersignal einstellbar ist. Die Stromspiegelanordnung besteht aus einer Strombank mit 8 Ausgängen, die abhängig von dem Datenwort DW, das seriell (oder auch parallel) in ein Register REG eingelesen und dort abgelegt wird, auf den stromgesteuerten Verstärker aufschaltbar sind. Die 8 Ausgänge weisen gegenüber dem Eingang der Strombank unterschiedliche Übersetzungsverhältnisse auf, wobei die Übersetzungsverhältnisse beim vorliegenden Ausführungsbeispiel so gewählt sind, daß ein logarithmischer Zusammenhang zwischen dem Datenwort DW und dem Faktor k besteht. Damit ist es möglich, die Verstärkungseinstellung über das Datenwort DW beispielsweise in Dezibel-Schritten vorzunehmen.

Um eine exakte Abstimmung der Übersetzungsverhältnisse zu erreichen, sind der Eingangszweig und die 8 Ausgangszweige jeweils aus identischen MOS-Transistoren aufgebaut, deren Anzahl jeweils unterschiedlich ist. So besteht der Eingangszweig der Strombank aus 50 bezüglich Gate, Drain und Source parallel geschalteten MOS-Transistoren TR1...TR50, bei denen Gate und Source jeweils miteinander und mit dem Kollektor des Transistors T3 und bei denen jeweils der Sourceanschluß mit dem Bezugspotential verbunden ist. Die Ausgangszweige bestehen jeweils aus einer bestimmten Anzahl von MOS-Feldeffekttransistoren, die bezüglich Source, Drain und Gate parallel geschaltet sind, wobei diese sourceseitig auf Bezugspotential liegen und die drainseitig mit jeweils einem, den entsprechenden Ausgangszweig zugeordneten steuerbaren Schalter S1...S8 verbunden sind. Die Gates sind miteinander und mit den Drainanschlüssen der Transistoren TR1...TR50 gekoppelt. Die steuerbaren Schalter S1...S8 werden jeweils durch ein Bit des im Register REG abgelegten Datenwortes DW gesteuert. Das Datenwort DW wird beispielsweise durch eine nicht näher dargestellte Kontrolleinheit seriell in das Register REG eingelesen. Die Anzahl der MOS-Transistoren in den einzelnen Ausgangszweigen ist entsprechend dem jeweils geforderten Übersetzungsverhältnis unterschiedlich. So sind bei dem dem höherwertigsten Bit des Datenwortes DW zugeordneten Ausgangszweig 160 MOS-Transistoren TA1...TA 160 und bei dem dem niederwertigsten Bit zugeordneten Ausgangszweig ein MOS-Transistor TA1 vorgesehen. Die anderen Ausgangszweige weisen 80 MOS-Transistoren TB1...TB80 bzw. 40 MOS-Transistoren TC1...TC40 bzw. 10 MOS-Transistoren TD1...TD10 bzw. fünf MOS-Transistoren TD1...TD5 bzw. drei MOS-Transistoren TF1...TF3 bzw. MOS-Transistoren TG1, TG2.

Neben der in Figur 2 gezeigten Ausgestaltung einer Multipliziereinrichtung sind darüber hinaus auch beispielsweise Ausführungsformen möglich, bei denen anstelle der gezeigten einstufigen Umsetzung mittels Stromspiegeln bzw. Strombänken eine Aufteilung in mehrere Stufen durch Hintereinanderschalten mehrerer insbesondere zueinander komplementären Stromspiegeln bzw. Strombänken erfolgt. Darüber hinaus sind aber ebenso mit Operational-Transductance-Amplifiers (OTAs) realisierte stromgesteuerte Stromverstärkerschaltungen, die analog oder digital angesteuert werden, oder multiplizierende Digital-Analog-Wandler mit Stromausgang anwendbar. Abschließend sei bemerkt, daß anstelle von Strombänken, die vorteilhafterweise aus identischen Transistoren aufgebaut sind, aber auch selbstverständlich ein Aufbau mit unterschiedlich dimensionierten Transistoren ohne weiteres möglich ist.

## Patentansprüche

1. Schaltungsanordnung
mit einem Stellglied (CCA), das in bestimmten Schwankungen und Streuungen unterworfener Abhängigkeit von einem Steuerstrom (is) einstellbar ist,
mit einer Konstantstromquelle (Q), deren Ausgangsstrom (ia) den bestimmten Schwankungen und Streuungen in gleicher Weise unterworfen ist, und
mit einer zwischen Konstantstromquelle (Q) und Stellglied (CCA) geschalteten Multipliziereinrichtung (MP1), die den von der Konstantstromquelle (Q) abgegebenen Strom (ia) um einen von einem Steuersignal (cs1) abhängigen Faktor (k) verändert und dem Stellglied (CCA) als Steuerstrom (is) zuführt.

2. Schaltungsanordnung nach Anspruch 1,
**dadurch gekennzeichnet,** daß zwischen Faktor (k) und Steuersignal (cs1) eine lineare Abhängigkeit besteht.

3. Schaltungsanordnung nach Anspruch 1,
**dadurch gekennzeichnet,** daß zwischen Faktor (k) und Steuersignal (cst) eine logarithmische Abhängigkeit besteht.

4. Schaltungsanordnung nach einem der Ansprüche 1 bis 3,
**dadurch gekennzeichnet,** daß die Multipliziereinrichtung (MP1) eine Stromspiegelanordnung aufweist, deren Übersetzungsverhältnis abhängig von dem Steuersignal (cs1) einstellbar ist.

5. Schaltungsanordnung nach Anspruch 4,
**dadurch gekennzeichnet**, daß als Steuersignal (cs1) ein binärkodiertes Datenwort (DW) vorgesehen ist, und daß die Stromspiegelanordnung eine Strombank aufweist, deren Ausgänge abhängig von dem Datenwort (DW) auf das Stellglied (CCA) aufschaltbar sind.

6. Schaltungsanordnung nach einem der Ansprüche 1 bis 5,
**dadurch gekennzeichnet**, daß Stellglied (CCA) und Konstantstromquelle (Q) in einer Technologie und die Multipliziereinrichtung (MP1) in anderer Technologie realisiert sind.

7. Schaltungsanordnung nach einem der Ansprüche 1 bis 6,
**dadurch gekennzeichnet**, daß neben der Multipliziereinrichtung (MP1) ein Stromdetektor (DT) an die Konstantstromquelle (Q) angeschlossen ist und daß die Konstantstromquelle (Q) ein- und ausschaltbar ist.

## Claims

1. Circuit arrangement,
having an actuator (CCA), which can be adjusted as a function of a control current (is), which function is subject to specific fluctuations and variations,
having a constant-current source (Q), the output current (ia) of which is subject to the specific fluctuations and variations in the same way, and
having a multiplying device (MP1), which is connected between the constant-current source (Q) and the actuator (CCA), changes the current (ia) output by the constant-current source (Q) by a factor (k) which depends on a control signal (cs1), and feeds the said current to the actuator (CCA) as the control current (is).

2. Circuit arrangement according to Claim 1, characterized in that a linear dependence exists between the factor (k) and the control signal (cs1).

3. Circuit arrangement according to Claim 1, characterized in that a logarithmic dependence exists between the factor (k) and the control signal (cst).

4. Circuit arrangement according to one of Claims 1 to 3, characterized in that the multiplying device (MP1) has a current mirror arrangement, the translation ratio of which can be adjusted as a function of the control signal (cs1).

5. Circuit arrangement according to Claim 4, characterized in that a binary-coded data word (DW) is provided as the control signal (cs1), and in that the current mirror arrangement has a current bank whose outputs can be connected to the actuator (CCA) as a function of the data word (DW).

6. Circuit arrangement according to one of Claims 1 to 5, characterized in that the actuator (CCA) and the constant-current source (Q) are implemented using one technology and the multiplying device (MP1) is implemented using another technology.

7. Circuit arrangement according to one of Claims 1 to 6, characterized in that, in addition to the multiplying device (MP1), a current detector (DT) is connected to the constant-current source (Q), and in that the constant-current source (Q) can be switched on and off.

## Revendications

1. Montage comportant
un organe (CCA) de réglage, qui peut être réglé en fonction d'un courant (is) de commande, cette fonction étant soumise à certaines fluctuations et dispersions,
une source (Q) de courant constant, dont le courant (ia) de sortie est soumis de la même manière auxdites certaines fluctuations et dispersions, et
un dispositif (MP1) de multiplication, qui est branché entre la source (Q) de courant constant et l'organe (CCA) de réglage et qui modifie d'un facteur (k) dépendant d'un signal (cs1) de commande le courant (ia) fourni par la source (Q) de courant constant et qui l'envoie en tant que courant (is) de commande à l'organe (CCA) de réglage.

2. Montage suivant la revendication 1,
caractérisé en ce qu'il existe une dépendance linéaire entre le facteur (k) et le signal (cs1) de commande.

3. Montage suivant la revendication 1,
caractérisé en ce qu'il existe une dépendance logarithmique entre le facteur (k) et le signal (cst) de commande.

4. Montage suivant l'une des revendications 1 à 3,
caractérisé en ce que le dispositif (MP1) de multiplication comporte un dispositif à miroir de courant, dont le taux de conversion peut être réglé en fonction du signal (cs1) de commande.

5. Montage suivant la revendication 4,
caractérisé en ce qu'il est prévu comme signal (cs1) de commande un mot (DW) de données codé de manière binaire et le dispositif de miroir de courant comporte un banc de courant, dont les sorties peuvent être branchées à l'organe (CCA) de réglage en fonction du mot (DW) de données.

6. Montage suivant l'une des revendications 1 à 5,
caractérisé en ce que l'organe (CCA) de réglage et la source (Q) de courant constant sont fabriqués suivant une certaine technologie et le dispositif (MP1) de multiplication est fabriqué suivant une autre technologie.

7. Montage sur l'une des revendications 1 à 6,
caractérisé en ce qu'outre le dispositif (MP1) de multiplication un détecteur (DT) de courant est connecté à la source (Q) de courant constant et la source (Q) de courant constant peut être branchée et débranchée.
